**Europäisches Patentamt**

**European Patent Office**

**Office européen des brevets**

(19)

(11) **EP 1 290 800 B1**

(12) **EUROPÄISCHE PATENTSCHRIFT**

(45) Veröffentlichungstag und Bekanntmachung des Hinweises auf die Patenterteilung:
**16.02.2005 Patentblatt 2005/07**

(51) Int Cl.$^7$: **H03L 7/091**

(21) Anmeldenummer: 01929630.0

(86) Internationale Anmeldenummer:
**PCT/EP2001/005227**

(22) Anmeldetag: **08.05.2001**

(87) Internationale Veröffentlichungsnummer:
**WO 2001/086816 (15.11.2001 Gazette 2001/46)**

(54) **DIGITALER PHASENREGELKREIS**

DIGITAL PHASE-LOCKED LOOP

BOUCLE A VERROUILLAGE DE PHASE NUMERIQUE

(84) Benannte Vertragsstaaten:
**DE FR GB**

(30) Priorität: **09.05.2000 DE 10022486**

(43) Veröffentlichungstag der Anmeldung:
**12.03.2003 Patentblatt 2003/11**

(73) Patentinhaber: **Infineon Technologies AG**
**81669 München (DE)**

(72) Erfinder:
• **DA DALT, Nicola**
**A-9523 Villach (AT)**

• **SANDNER, Christoph**
**A-9500 Villach (AT)**

(74) Vertreter: **Barth, Stephan Manuel, Dr.**
**Reinhard-Skuhra-Weise & Partner Gbr,**
**Patentanwälte**
**Friedrichstrasse 31**
**80801 München (DE)**

(56) Entgegenhaltungen:
**EP-A- 0 758 171       US-A- 4 577 163**
**US-A- 5 258 724**

**Beschreibung**

Die vorliegende Erfindung betrifft einen Phasenregelkreis gemäß dem Oberbegriff des Anspruchs 1, wie aus der US 5,727,038 bekannt.

Aus der US 5,727,038 ist ein Phasenregelkreis, welcher einen Phasendetektor, einen digitalen Schleifenfilter, einen digital gesteuerten Oszillator und einen Teilerschaltkreis aufweist, um ein Signal mit einer festen vorbestimmten Phase bezogen auf ein Referenzsignal zur erzeugen. Ein Phasendetektor erzeugt ein erstes Steuersignal ansprechend auf die Phasenbeziehung zwischen dem Referenzsignal und einem rückgekoppelten Signal. Der digitale Filter empfängt das erste Steuersignal und generiert daraus ein zweites Steuersignal, wobei das zweite Steuersignal in digitaler Form vorliegt. Der digital kontrollierte Oszillator verarbeitet dieses zweite Steuersignal, so dass er eine Frequenz entsprechend dem zweiten Steuersignal ausgibt.

Aus der US 6,005,425 ist ein digitaler Phasenregelkreis bekannt. Ein Phasenfehlerdetektor erzeugt ein Phasenfehlersignal, dessen Breite zu der Größe des Phasenfehlers korrespondiert. Ein Pulsweitendetektor quantisiert die Pulsweite. Der quantisierte Wert wird in einem Zwischenspeicher abgelegt. Aus dem Zwischenspeicher wird der zuletzt quantisierte Wert geladen und mit dem aktuellen durch einen Komparator verglichen. Der Komparator gibt entsprechend einer Änderung des Phasenfehlersignals ein Steuersignal an einen digital gesteuerten Oszillator.

Aus der US-A-6,005,427 ist ein digitaler Phasenregelkreis mit einem Phasendetektor zum Erfassen der analogen Phasendifferenz zwischen einem Eingangssignal und einem Ausgangssignal eines digital gesteuerten Oszillators bekannt, wobei das digitale Ausgangssignal des Phasendetektors einem digitalen Schleifenfilter zugeführt wird, dessen Ausgangssignal dann dem digital gesteuerten Oszillator zur Einstellung seines Ausgabetakts zugeführt wird.

Die US-A-6,052,034 sowie die US-A-6,028,488 offenbaren digitale Phasenregelkreise, bei denen ein digitales Schleifenfilter verwendet wird.

Walters, S.M. and Troudet, T. "Digital Phase Locked Loop with Jitter Bounded" in: IEEE Transact. on Circuits and Systems, Vol. 36, Nr. 7, Juli 1989, Seiten 980 bis 986 offenbart einen digitalen Phasenregelkreis, wobei ein jeweiliger Frequenzteiler für Referenztakt und Ausgangstakt vorgesehen ist.

Shayan, Y.R. and Le-Ngoc, T. "All digital phase-locked loop: concepts, design and applications", in: IEE Proceedings, Vol. 136, Nr. 1, 1989, Seiten 53 bis 56 offenbart einen weiteren bekannten rein digitalen Phasenregelkreis.

Die vorliegende Erfindung betrifft einen digitalen Phasenregelkreis zur Erzeugung eines Taktsignals mit Hilfe eines digital gesteuerten Oszillators ("Digitally Controlled Oscillator", DCO),wobei das Taktsignal eine definierte Phasen- und Frequenzbeziehung zu einem Referenztaktsignal aufweist.

Zur Erzeugung von Frequenzen, die auf eine bestimmte Referenzfrequenz synchronisiert sind, ist die Verwendung von analogen Phasenregelkreisen ("Phase Locked Loop", PLL) bekannt. Ein derartiger analoger Phasenregelkreis ist beispielsweise aus der Druckschrift F.M. Gardner, "Charge-Pump Phase-Locked Loops", IEEE Trans. Comm. Bd. 28, S. 1849-1858, November 1980 bekannt. Dieser analoge Phasenregelkreis umfaßt einen Phasen/Frequenz-Detektor ("Phase/Frequency Detector", PFD), der den Ausgabetakt eines spannungsgesteuerten Oszillators ("Voltage Controlled Oscillator", VCO) mit einem Referenztakt vergleicht und als Ausgangssignal Spannungsimpulse erzeugt, welche die Information der Phasen- und Frequenzdifferenz zwischen dem Ausgabetakt des spannungsgesteuerten Oszillators und dem Referenztakt enthalten. Die Spannungsimpulse werden einer Ladungspumpe zugeführt, welche die Spannungsimpulse in entsprechende Stromimpulse umsetzt, wobei diese Stromimpulse ihrerseits von einem Transimpedanz-Schleifenfilter erster oder höherer Ordnung integriert werden. Der spannungsgesteuerte Oszillator wird schließlich durch das Ausgangssignal des Schleifenfilters angesteuert, um seinen Ausgabetakt entsprechend einzustellen. Im Rückkopplungspfad zwischen dem spannungsgesteuerten Oszillator und dem Phasen/Frequenz-Detektor kann ein Teiler angeordnet sein, so daß dem Phasen/Frequenz-Detektor der Ausgabetakt des spannungsgesteuerten Oszillators geteilt durch einen Faktor N zugeführt wird, wobei N eine beliebige positiver Zahl sein kann. Im eingeregelten Zustand des Phasenregelkreises entspricht somit die Ausgabefrequenz des spannungsgesteuerten Oszillators der N-fachen Referenzfrequenz.

Wird eine hohe Frequenzauflösung mit niedrigem Jitter gefordert, ist die Verwendung eines digital gesteuerten Oszillators ("Digitally Controlled Oscillator", DCO) vorteilhaft. Diesbezüglich wurden verschiedene Phasenregelkreis-Architekturen vorgeschlagen, wobei bisher die Ladungspumpen und Schleifenfilter stets mit analogen Komponenten realisiert worden sind.

So ist beispielsweise aus der Druckschrift J. Chiang, H. Chen, "A 3.3 all digital phase locked loop with small DCO hardware and fast phase lock", Proceedings of the 1998 IEEE International Symposium on Circuits and Systems, ISCAS '98, Bd. 1, ein digitaler Phasenregelkreis bekannt, wobei anstelle des analogen Phasen/Frequenz-Detektors ein digitaler Phasendetektor und ein davon separat vorgesehener digitaler Frequenzdetektor verwendet werden. Dadurch ist die Komplexität des Gesamtsystems erhöht. Zudem ist bei Verwendung von digitalen Phasen- oder Frequenzdetektoren in der Regel die minimale Auflösung schlechter als bei Verwendung von analogen Phasen- oder Frequenzdetektoren. Des weiteren wird in dieser Druckschrift vorgeschlagen, eine Steuerlogik des digital gesteuerten Oszillators zu verwenden, die zwischen die digitalen Phasen- und Frequenzdetektoren und den digital gesteuerten Oszillator geschaltet ist. Diese Steuerlogik führt spezielle Steuerabläufe aus, die nicht oder nur mit erheblichem Aufwand verallgemeinert werden können, so daß der in dieser Druckschrift beschriebene digitale Phasenregelkreis nicht für unterschiedliche Anwendungen geeignet ist.

Auch aus der US 5,162,746 A ist ein digitaler Phasenregelkreis bekannt, wobei ein digitaler Phasendetektor in Kombination mit einem Aufwärts/Abwärts-Zähler verwendet wird und das Ausgangssignal des Aufwärts/Abwärts-Zählers über einen entsprechend ausgestalteten Decoder einem digital gesteuerten Oszillator zur entsprechenden Einstellung seines Ausgabetakts zugeführt wird.

Ein weiterer digitaler Phasenregelkreis ist in der Druckschrift M. Izumikawa, M. Yamashina, "Compact realization of Phase-Locked loop using digital control", IEICE Trans. Electron., Bd. E80-C, Nr. 4, April 1997, beschrieben, wobei anstelle eines digital gesteuerten Oszillators ein analoger, spannungsgesteuerter Oszillator verwendet wird, dessen Ausgabetakt von einem numerischen Phasendetektor mit einem Referenztakt verglichen wird. Das von dem numerischen Phasendetektor erzeugte digitale Stellsignal wird über ein digitales Schleifenfilter einem Digital/Analog-Wandler zugeführt, um die digitalen Stellwerte in entsprechende analoge Stellwerte für den spannungsgesteuerten Oszillator umzusetzen. Dabei entspricht die Anzahl der digitalen Stellwerte der Frequenzauflösung dieses Phasenregelkreises.

Die bisher vorgeschlagenen Architekturen für einen Phasenregelkreis mit einem digital gesteuerten Oszillator erschweren eine Stabilitätsanalyse des Phasenregelkreises oder machen diese sogar unmöglich, da von dem Entwickler die Übertragungsfunktion des jeweils verwendeten Schleifenfilters und damit die Phasen- und Verstärkungsstabilitätsgrenzen des Phasenregelkreise nicht oder nur mit erheblichem Aufwand variiert werden können. Die für die jeweils gewünschte Anwendung am besten geeignete Übertragungsfunktion des Schleifenfilters kann somit nicht frei gewählt werden.

Der vorliegenden Erfindung liegt daher die Aufgabe zugrunde, einen digitalen Phasenregelkreis mit einem digital gesteuerten Oszillator vorzuschlagen, der die Verwendung eines beliebigen digitalen Schleifenfilters ermöglicht, so daß der Entwickler stets die für die jeweilige Anwendung am besten geeignete Übertragungsfunktion wählen kann.

Insbesondere soll die Phasendetektoreinrichtung die zeitlich konzentrierte Phasendifferenzinformation in eine über die Zeitachse verteilte Phaseninformation in Form eines numerischen digitalen Stellenwertes umsetzen, der dann auf geeignete Art und Weise in dem digitalen Schleifenfilter integriert werden kann.

Diese Aufgabe wird erfindungsgemäß durch einen digitalen Phasenregelkreis mit den Merkmalen des Anspruches 1 gelöst. Die Unteransprüche definieren jeweils bevorzugte und vorteilhafte Ausführungsformen der vorliegenden Erfindung.

Zur Lösung der oben genannten Aufgabe wird erfindungsgemäß eine allgemeingültige Struktur für einen Phasenregelkreis mit einem digital gesteuerten Oszillator vorgeschlagen. Der erfindungsgemäße digitale Phasenregelkreis umfaßt einen digital gesteuerten Oszillator zur Erzeugung eines bestimmten Ausgabetakts, eine Phasendetektoreinrichtung zum Erfassen der analogen Phasendifferenz zwischen dem Ausgabetakt des digital gesteuerten Oszillators und einem Referenztakt und zum Umsetzen der somit erfaßten analogen Phasendifferenz in einen entsprechenden digitalen Stellwert für den digital gesteuerten Oszillator sowie ein digitales Schleifenfilter, über welches der digitale Stellwert der Phasendetektoreinrichtung dem digital gesteuerten Oszillator zur entsprechenden Einstellung seines Ausgabetakts zugeführt ist.

Bei der Phasendetektoreinrichtung des erfindungsgemäßen digitalen Phasenregelkreises handelt es sich um einen Phasen/Frequenz-Analog/Digital-Wandler ("Phase/Frequency Analog to Digital Converter", PFDC), der die durch den Vergleich des Ausgabetakts des digital gesteuerten Oszillators mit dem Referenztakt gewonnene Phasen- und Frequenzinformation derart quantisiert, daß sie nicht mehr wie bei herkömmlichen analogen Ladungspumpen-Phasenregelkreisen in kurzen Strom- bzw. Spannungsimpulsen konzentriert ist, sondern in einen digitalen Stellwert umgesetzt und gleichmäßig entlang der Zeitachse verteilt wird. Dazu wird der digitale Stellwert in einem Ausgaberegister ausgegeben. Der Wert in dem Ausgaberegister bleibt so lange erhalten, bis ein neuer Phasenfehler quantisiert wurde. Der Vorteil dieser Lösung besteht darin, daß die Ladungspumpe entfällt und das analoge Schleifenfilter durch jede beliebige Art eines digitalen Schleifenfilters ersetzt wird. Der Entwickler kann somit das digitale Schleifenfilter mit der für die jeweils gewünschte Anwendung am besten geeignete Übertragungsfunktion wählen. Mit Hilfe der vorliegenden Erfindung kann der gesamte Phasenregelkreis auf klassische Art und Weise wie ein vollständig analoges System betrachtet und insbesondere hinsichtlich seiner Stabilität analysiert werden, wobei die Phasen- und Verstärkungsstabilitätsgrenzen einfach berechnet und variiert werden können. Anschließend kann das digitale Schleifenfilter mit Hilfe herkömmlicher Techniken als Ersatz für ein zeitkontinuierliches Filter entwickelt werden. Als digitales Schleifenfilter kann beispielsweise ein IIR-Filter, ein FIR-Filter, ein Wellendigitalfilter oder ein bilineares Transformationsfilter etc. verwendet werden.

Insgesamt wird somit die Entwicklung des Phasenregelkreises deutlich vereinfacht. Die im wesentlichen digitale Designstrategie stellt einen offensichtlichen Vorteil dar, da die Übertragung des Schaltungsdesigns auf kleinere Chips oder modernere Technologien deutlich vereinfacht und beschleunigt wird und der jeweils benötigte Chipbereich insbesondere für den Fall sehr geringer Resonanzfrequenzen deutlich reduziert werden kann.

Das Prinzip ist jedoch nicht auf integrierte Schaltungen beschränkt, sondern auch auf beliebige, z. B. diskret aufgebaute, Regelkreise anwendbar.

Im Rückkopplungspfad des erfindungsgemäßen Phasenregelkreises können ein oder mehrere Frequenzteiler angeordnet sein. Ebenso kann die Referenzfrequenz durch einen oder mehrere Frequenzteiler heruntergeteilt werden, ehe sie der erfindungsgemäßen Phasendetektoreinrichtung zugeführt wird.

Aufgrund der Verwendung eines digital gesteuerten Oszillators eignet sich die vorliegende Erfindung insbesondere für alle Anwendungsfälle der Frequenzsynthese, wo eine hohe Frequenzauflösung mit geringem Jitter gewünscht wird.

Die vorliegende Erfindung wird nachfolgend unter Bezugnahme auf die Zeichnung anhand eines bevorzugten Ausführungsbeispiels näher beschrieben.

Figur 1     zeigt ein vereinfachtes Blockschaltbild eines digitalen Phasenregelkreises gemäß einem bevorzugten Ausführungsbeispiel der vorliegenden Erfindung,

Figur 2     zeigt den Aufbau einer in Figur 1 gezeigten Phasendetektoreinrichtung,

Figur 3     zeigt eine Darstellung zur Verdeutlichung der Funktionsweise der in Figur 1 und Figur 2 gezeigten Phasendetektoreinrichtung,

Figur 4     zeigt den Aufbau eines in Figur 2 gezeigten Flankendetektors, und

Figur 5     zeigt den Aufbau eines in Figur 2 gezeigten Quantisierers.

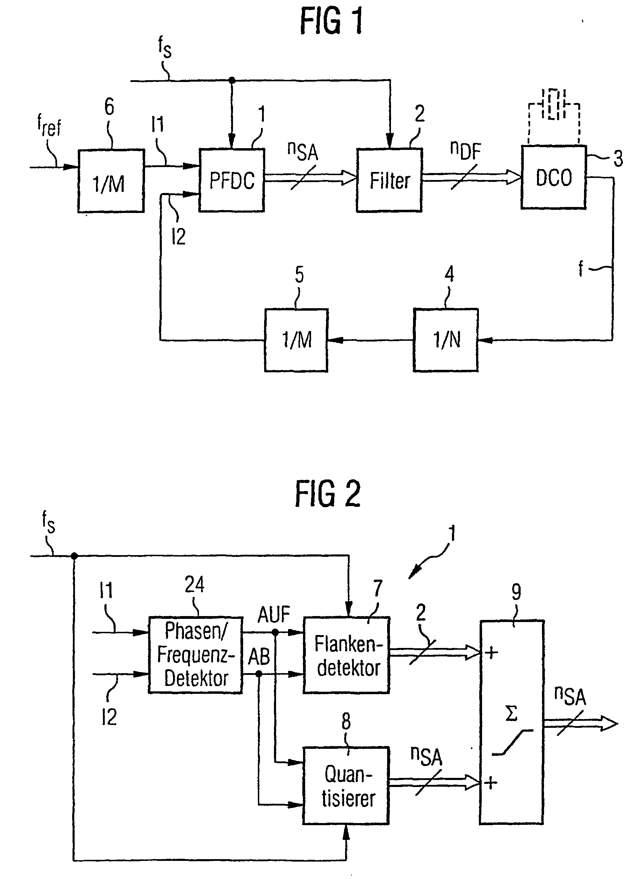

Der in Figur 1 gezeigte digitale Phasenregelkreis umfaßt als wesentliche Bestandteile eine als Phasen/Frequenz-Analog/Digital-Umsetzer ("Phase/Frequency Analog to Digital Converter", PFDC) ausgestaltete Phasen/Frequenz-Detektoreinrichtung 1, ein passendes digitales Schleifenfilter 2 und einen digital gesteuerten Oszillator ("Digitally Controlled Oscillator", DCO). Des weiteren ist bei dem in Figur 1 gezeigten Ausführungsbeispiel im Rückkopplungszweig ein Frequenzteiler 4 vorgesehen, der die Ausgabefrequenz f des digital gesteuerten Oszillators 3 mit dem Teilerfaktor 1/N teilt, wobei N eine beliebige positive Zahl sein kann. Zusätzlich kann ein weiterer Frequenzteiler 5 mit dem Teilerfaktor 1/M vorgesehen sein. Auch für den Referenztakt oder die Referenzfrequenz $f_{ref}$ der Phasendetektoreinrichtung 1 kann ein weiterer Frequenzteiler 6 mit dem Teilerverhältnis 1/M vorgesehen sein. Die beiden Frequenzteiler 5 und 6 sind insbesondere dann vorteilhaft, wenn die Betriebstaktfrequenz $f_s$ der Phasendetektoreinrichtung 1 und des digitalen Schleifenfilters 2 nicht ausreichend höher als die Frequenztaktfrequenz $f_{ref}$ ist.

Bei dem in Figur 1 gezeigten Ausführungsbeispiel wird der Referenztakt $f_{ref}$ von dem Frequenzteiler 6 mit dem Teilerfaktor 1/M heruntergeteilt und anschließend als Eingangssignal I1 der Phasendetektoreinrichtung 1 zugeführt. Die Phasendetektoreinrichtung 1 empfängt als weiteres Eingangssignal 12 den zuvor von den Frequenzteilern 4 und 5 mit den Teilerfaktoren 1/N bzw. 1/M heruntergeteilte Ausgabetakt f des digital gesteuerten Oszillators 3. Die Phasendetektoreinrichtung 1 erfaßt die Phasendifferenz zwischen den beiden Eingangssignalen I1 und I2, quantisiert diese auf geeignete Art und Weise und setzt die Phasendifferenz somit in einen numerischen digitalen Stellwert um, der über einen Bus mit einer geeigneten Busbreite $n_{SA}$ dem digitalen Schleifenfilter 2 zugeführt wird. Die Architektur des digitalen Schleifenfilters 2 ist vollkommen unabhängig von der Ausgestaltung der Phasendetektoreinrichtung 1. Der digitalen Ausgangswert des digitalen Schleifenfilters 2 wird über einen weiteren Bus mit der Busbreite $n_{DF}$ dem digital gesteuerten Oszillator 3 zugeführt, um somit direkt seine Ausgangsfrequenz f entsprechend einzustellen bzw. zu steuern.

Wie bereits erwähnt worden ist, kann als digitales Schleifenfilter 2 im Prinzip jede beliebige Digitalfilterart beliebiger Ordnung verwendet werden. So kann das digitale Schleifenfilter 2 beispielsweise als FIR-Filter ("Finite Impulse Response"), IIR-Filter ("Infinite Impulse Response") oder als Wellendigitalfilter ausgestaltet sein. Die konkrete Ausgestaltung des digitalen Schleifenfilters 2 ist dem jeweils zuständigen Entwickler in Abhängigkeit von den Stabilitätserfordernissen, der Resonanzfrequenz usw. überlassen. Auch der digital gesteuerte Oszillator 3 kann im Prinzip beliebig ausgestaltet sein. Die einzige Aufgabe des digital gesteuerten Oszillators 3 besteht darin, eine Ausgangsfrequenz f zu erzeugen, die proportional zu seinem digitalen Eingangswert ist. Wird eine hohe Frequenzauflösung mit geringem Jitter benötigt, kann der digital gesteuerte Oszillator 3 beispielsweise als Quarzoszillator ausgestaltet sein.

In Figur 2 ist ein möglicher Aufbau der in Figur 1 gezeigten Phasendetektoreinrichtung 1 im Detail dargestellt. Die Phasendetektoreinrichtung 1 umfaßt dabei im wesentlichen einen analogen Phasen/Frequenz-Detektor ("Phase/Frequency Detector", PFD), einen Flankendetektor ("Edge Detector", ED), einen Quantisierer oder Abtaster ("Sampler", SA) und einen arithmetischen Addierer 9, der die Ausgangswerte des Flankendetektors 7 und des Quantisierers 8 mittels Zweierkomplement-Addition addiert. Dabei verfügt der Addierer 9 über eine Begrenzung zur Verhinderung eines Überlaufs.

Bei dem Phasen/Frequenz-Detektor 24 handelt es sich um einen herkömmlichen analogen Phasen/Frequenz-Detektor, der die beiden Eingangssignale I1 und I2 miteinander vergleicht und abhängig von der Phasendifferenz zwischen diesen beiden Eingangssignalen I1 und I2 impulsförmige Ausgangssignale AUF und AB erzeugt, die entweder einen hohen Pegel (entsprechend dem binären Wert "1") oder einen niedrigen Pegel (entsprechend dem binären "0") annehmen können. In der Pulsbreite der AUFund AB-Impulse ist die Information über die Phasen/Frequenz-Differenz zu den Eingangssignalen I1 und I2 enthalten. Die Ausgangssignale des Phasen/Frequenz-Detektors 24 werden jeweils dem Flankendetektor 7 und dem Quantisierer 8 zugeführt.

Die Aufgabe des Quantisierers 8 besteht darin, die "zeitlich konzentrierte" Phasendifferenzinformation des Phasen/Frequenz-Detektors 24 in eine über die Zeitachse "verteilte" Phasendifferenzinformation in Form eines numerischen digitalen Stellwerts umzusetzen, der dann auf geeignete Art und Weise in dem digitalen Schleifenfilter 2 (vgl. Figur 1) integriert werden kann.

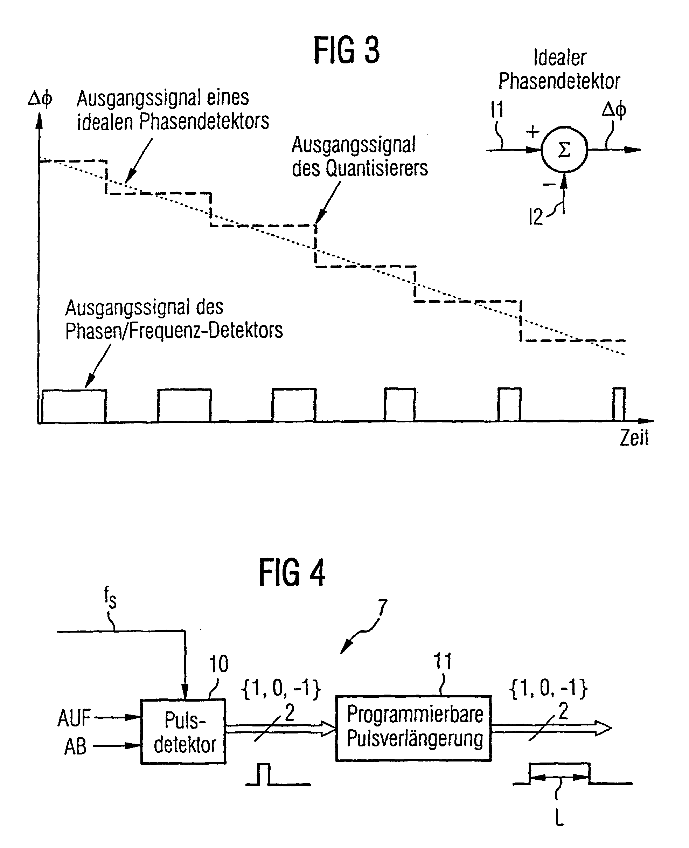

Dies bedeutet in anderen Worten, daß die Kombination bestehend aus dem Phasen/Frequenz-Detektor 24 und dem Quantisierer 8 digital das Verhalten eines "idealen" analogen Phasendetektors nachbildet. Dies wird auch anhand der Darstellung von Figur 3 deutlich, wo einerseits das Ausgangssignal eines idealen Phasendetektors und andererseits das Ausgangssignal des Quantisierers 8 sowie das Ausgangssignal des Phasen/Frequenz-Detektors 24 in Abhängigkeit von der Zeit dargestellt ist. Wie aus Figur 3 ersichtlich ist, kann das Ausgangssignal des Quantisierers 8 als zeitlich abgetastete Version des Ausgangssignals eines idealen Phasendetektors angesehen werden. Dieses Konzept ermöglicht eine deutliche Vereinfachung des Designs des Phasenregelkreises, da der gesamte Phasenregelkreis auf klassische Art und Weise als ein vollständig analoges System betrachtet und das digitale Schleifenfilter 2 einfach mit Hilfe herkömmlicher Techniken ausgewählt werden kann. Aus Figur 3 ist auch ersichtlich, wie die Pulsbreite der von dem Phasen/Frequenz-Detektor 24 erzeugten Impulse mit zunehmender Verringerung des Phasenfehlers $\Delta\phi$ abnimmt.

Der Betrieb des Quantisierers 8 erfolgt vollständig synchron zu dem digitalen Taktsignal $f_s$, so daß die minimale Phasenauflösung des Quantisierers 8 durch das Verhältnis zwischen der von dem Teiler 6 geteilten Referenzfrequenz $f_{ref}$ und der Betriebsfrequenz $f_s$ definiert ist. Wird das Teilerverhältnis der Teiler 5 und 6 mit 1/M und das Teilerverhältnis 4 mit 1/N bezeichnet und wird angenommen, daß die Betriebsfrequenz $f_s$ des Quantisierers 8 der doppelten Ausgangsfrequenz f des digital gesteuerten Oszillators 3 entspricht (was auf einfache Art und Weise mit einer kleinen Digitalschaltung erzielt werden kann), so ist die minimale Phasenauflösung wie folgt definiert:

$$\Delta\phi = \frac{1}{2MN}$$

Die Teilerfaktoren M und N können somit genutzt werden, um die minimale Phasenauflösung des Quantisierers 8 zu verbessern. Beträgt beispielsweise N=64 und M=8, so beträgt die minimale Phasenauflösung $\Delta\phi$=1/1024, was vergleichbar zu der Auflösung eines 10 bit-A/D-Wandlers ist. Wie später noch ausführlicher beschrieben wird, beträgt der Wertebereich des Quantisierers 8 [-2MN+1,2MN-1], wobei die minimale Anzahl der Ausgabebits des Quantisierers 8 einschließlich des Vorzeichenbits wie folgt definiert ist:

$$n_{SA} = \log_2(2MN)+1$$

Durch das Einfügen der zusätzlichen Frequenzteiler 5 und 6 wird die Verstärkung des offenen Phasenregelkreises um M verringert. Dies kann jedoch einfach durch eine geeignete Wahl der Verstärkung des digitalen Schleifenfilters 2 kompensiert werden.

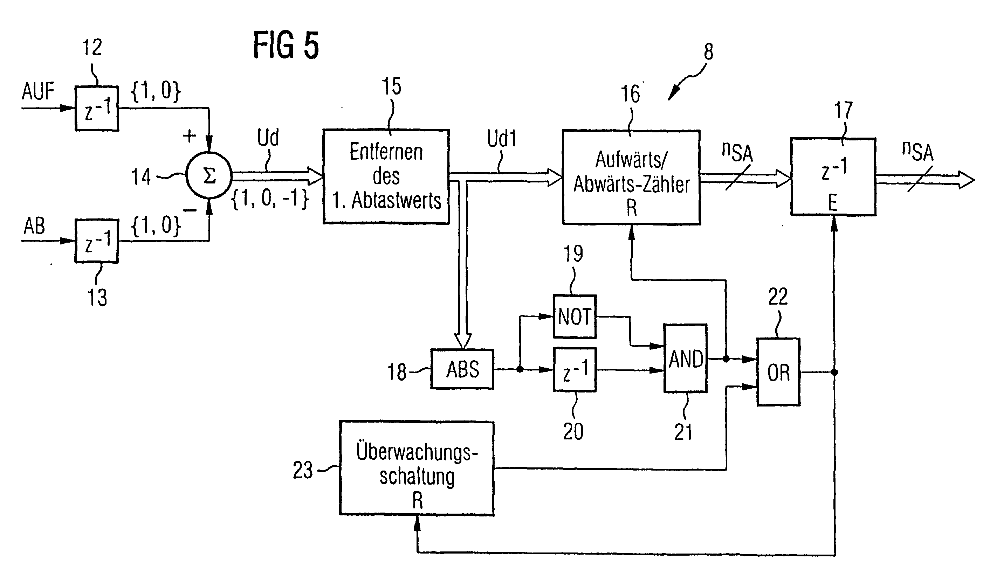

Nachfolgend soll der Betrieb des Quantisierers 8 ausführlicher unter Bezugnahme auf Figur 5 erläutert werden, wobei in Figur 5 eine mögliche Struktur des Quantisierers 8 dargestellt ist.

Wie in Figur 5 gezeigt ist, werden die beiden Ausgangssignale AUF und AB des Phasen/Frequenz-Detektors 24 mit Hilfe von Registern 12 und 13 abgetastet, wobei die sich jeweils entsprechenden Abtastwerte der beiden Signale von einem Subtrahierer 14 subtrahiert werden, um ein Zwischensignal Ud zu erhalten, welches die Werte 1,0 und -1 annehmen kann. Das Signal Ud ist ein gepulstes Signal, dessen Form ähnlich zu der Form der Signale AUF und AB ist. Die Impulslänge der einzelnen Pulse des Signals Ud ist ein Maß für die Phasendifferenz zwischen den beiden Eingangssignalen I1 und I2 des Phasen/Frequenz-Detektors 24.

Der erste Abtastwert jedes Ud-Impulses wird von einer einfachen digitalen Schaltung 15 entfernt, so daß das daraus resultierende Signal Ud1 dem Eingang eines Aufwärts/Abwärts-Zählers 16 zugeführt wird. Der Zähler 16 verändert seinen Zählerstand in Abhängigkeit von dem jeweiligen Wert des Signals Ud1, wobei der Zählerstand erhöht bzw. erniedrigt wird, wenn das Signal Ud1 positiv bzw. negativ ist, während der Zählerstand unverändert bleibt, wenn das Signal Ud1 Null ist. Der von diesem Aufwärts/Abwärts-Zähler 16 zum Ende eines jeden Impulses gelieferte Ausgangswert entspricht somit einfach der vorzeichenbehafteten Länge der Ud1-Impulse, wobei der Ausgangswert des Aufwärts/Abwärts-Zählers 16 im Bereich -2MN+1 und 2MN-1 liegen kann.

In Figur 5 ist auch ein Schaltungsteil mit einem Absolutwertbilder 18, einem logischen NOT-Glied 19, einem Register 20, einem logischen AND-Glied 21 und einem logischen OR-Glied 22 dargestellt, wobei das AND-Glied 21 immer dann, wenn ein Udl-Impuls vorüber ist, einen Reset-Impuls erzeugt und an einen Reset-Eingang des Aufwärts/Abwärts-Zählers 16 anlegt, um den Zählerstand wieder auf Null zurückzusetzen. Des weiteren wird über den Ausgang des OR-Glieds 22 nach jedem Ud1-Impuls ein Freigabeimpuls an einen Freigabeanschluß eines Ausgaberegisters 17 angelegt, so daß das Endergebnis des Aufwärts/Abwärts-Zählers 16 als Ausgabewert ausgegeben wird. Dieser Ausgabewert wird so lange beibehalten, bis ein neuer Udl-Impuls auftritt.

In Figur 5 ist zudem eine Überwachungsschaltung 23 dargestellt, um den letzten Ausgabewert des Quantisierers 8 bzw. des Aufwärts/Abwärts-Zählers 16 zu entfernen (im eingeregelten Zustand des Phasenregelkreises nimmt das Signal Ud1 dauernd den Wert Null an, so daß lediglich der in Figur 2 gezeigte Flankendetektor 7 der Phasendetektoreinrichtung 1 arbeitet, während sich der Zustand des Quantisierers 8 nicht verändert). Die Überwachungsschaltung 23 kann einfach in Form eines Zählers realisiert sein, der zusammen mit dem Aufwärts/Abwärts-Zähler 16 zurückgesetzt wird und ansonsten kontinuierlich aufwärts zählt. Übersteigt der Zählerstand dieses Zählers 23 unter Berücksichtigung einer vertretbaren Toleranzgrenze den Wert 2MN (was bedeutet, daß das Signal Ud1 keine Impulse aufweist), so wird ein Freigabeimpuls erzeugt, und der letzte Ausgabewert des Registers 17 wird durch den Wert Null ersetzt.

Befindet sich der Phasenregelkreis fast im eingeregelten Zustand, reicht die Phasenauflösung des Quantisierers 8 nicht aus. In diesem Fall sind die von dem in Figur 2 gezeigten Phasen/Frequenz-Detektor 24 erzeugten Impulse so kurz, daß sie von dem Quantisierer 8 kaum abgetastet werden können. Daher ist gemäß Figur 2 der als Flankendetektor bezeichnete Schaltungsblock 7 vorgesehen, um die Phasenauflösung und damit insbesondere den Betrieb im eingeregelten Zustand des Phasenregelkreises weiter zu verbessern. Ein möglicher Aufbau des Flankendetektors 7 ist in Figur 4 dargestellt.

Wie in Figur 4 gezeigt ist, umfaßt der Flankendetektor 7 zwei Schaltungsblöcke 10 und 11. Der als Pulsdetektor bezeichnete Schaltungsblock 10 empfängt als Eingangssignale die AUF- und AB-Impulse des Phasen/Frequenz-Detektors 24. Jedesmal, wenn an einem der Eingänge des Pulsdetektors 10 ein Impuls auftritt, stellt der Pulsdetektor 10 fest, ob zuerst ein AUF-Impuls oder ein AB-Impuls aufgetreten ist. Daraufhin erzeugt der Pulsdetektor 10 einen einzelnen Impuls, dessen Dauer der Taktperiode des digitalen Taktsignals $f_s$ entspricht, wobei dieser Einzelimpuls beispielsweise den Wert "1" annimmt, falls zuerst ein AUF-Impuls aufgetreten ist, während der Einzelimpuls den Wert "-1" annimmt, falls zuerst ein AB-Impuls aufgetreten ist. Wurde an den Eingängen des Pulsdetektors 10 kein Impuls festgestellt, weist der von dem Pulsdetektor 10 erzeugte Einzelimpuls den Wert Null auf. Der von dem Pulsdetektor 10 erzeugte Einzelimpuls enthält somit eine Information darüber, welches der beiden pulsförmigen Signale AUF und AB vorauseilt, und kann dazu benutzt werden, um den dem digitalen Schleifenfilter 2 zugeführten digitalen Stellwert geringfügig zu korrigieren.

Zu diesem Zweck wird der von dem Pulsdetektor 10 erzeugte Einzelimpuls auf eine Dauer von L Taktperioden des digitalen Taktsignals $f_s$ ausgedehnt. Der Schaltungsblock 11 kann beispielsweise durch ein Kammfilter erster Ordnung realisiert sein. Der Faktor L kann programmierbar sein und Werte zwischen 1 und MN annehmen. Durch diese Maßnahme wird die minimale Auflösung um den Faktor L/MN verbessert, so daß die minimale Phasenauflösung wie folgt definiert ist:

$$\Delta\phi = \frac{1}{2MN} \cdot \frac{L}{MN}$$

Beträgt beispielsweise N=64, M=8 und L=8, so ergibt sich für die minimale Phasenauflösung $\Delta\phi = 1/65536$, was vergleichbar zu der Auflösung eines 16 bit-A/D-Wandlers ist.

Wie in Figur 2 gezeigt ist, wird der auf diese Weise von dem Flankendetektor 7 erzeugte digitale Korrekturwert durch den Addierer 9 zu dem von dem Quantisierer 9 erzeugten digitalen Stellwert hinzuaddiert, so daß der daraus resultierende digitale Summenwert als endgültiger Stellwert dem in Figur 1 gezeigten digitalen Schleifenfilter 2 und anschließend dem digital gesteuerten Oszillator 3 zur entsprechenden Einstellung dessen Ausgangsfrequenz f zugeführt wird.

**Patentansprüche**

**1.** Digitaler Phasenregelkreis,
mit einem digital gesteuerten Oszillator (3) zur Erzeugung eines bestimmten Ausgabetakts (f),
mit einer Phasendetektoreinrichtung (1) zum Erfassen der analogen Phasendifferenz zwischen einem von dem Ausgabetakt (f) des digital gesteuerten Oszillators (3) abhängigen Takt und einem Referenztakt ($f_{ref}$) und zum Umsetzen der erfaßten analogen Phasendifferenz in einen entsprechenden digitalen Stellwert für den digital gesteuerten Oszillator (3), und
mit einem digitalen Schleifenfilter (2), über welches der digitale Stellwert der Phasendetektoreinrichtung (1) dem digital gesteuerten Oszillator (3) zur Einstellung seines Ausgabetakts (f) zugeführt ist,
wobei die Phasendetektoreinrichtung (1) einen Phasendetektor (24) und eine Quantisiereinrichtung (8) umfaßt,
wobei der Phasendetektor (24) in Abhängigkeit von der Phasendifferenz ein erstes Impulssignal (AUF) und ein zweites Impulssignal (AB) erzeugt, wobei ein Impuls des ersten Impulssignals (AUF) erzeugt wird, wenn der von dem Ausgabetakt (f) des digital gesteuerten Oszillators (3) abhängige Takt kleiner als der Referenztakt ($f_{ref}$) ist, während ein Impuls des zweiten Impulssignals (AB) erzeugt wird, wenn der von dem Ausgabetakt (f) des digital gesteuerten Oszillators (3) abhängige Takt größer als der Referenztakt ($f_{ref}$) ist, und

wobei die Quantisiereinrichtung (8) einen ersten Schaltungsabschnitt (12-14) zum Abtasten des ersten und zweiten Impulssignals (AUF, AB) und zum Subtrahieren der somit gewonnenen Abtastwerte des ersten und zweiten Impulssignals (AUF, AB) aufweist, um somit einen entsprechenden digitalen Differenzwert (Ud) zu erzeugen, und

daß die Quantisiereinrichtung (8) einen Zähler (16) aufweist, dessen Zählerstand in Abhängigkeit von dem jeweils erzeugten digitalen Differenzwert (Ud) des ersten Schaltungsabschnitts (12-14) verändert wird, wobei der Zählerstand des Zählers (16) als Grundlage für den digitalen Stellwert dient,

**dadurch gekennzeichnet,**

**daß** die Quantisiereinrichtung (8) einen zweiten Schaltungsabschnitt (18-22) aufweist, der derart ausgestaltet ist, daß das von dem ersten Schaltungsabschnitt (12-14) erzeugte digitale Differenzwertsignal auf das Ende eines Impulses hin überwacht wird und in diesem Fall ein Rücksetzsignal für den Zähler (16) zum Zurücksetzen dessen Zählerstands erzeugt wird, und

**daß** die Quantisiereinrichtung (8) ein Ausgaberegister (17) aufweist, über welches der augenblickliche Zählerstand des Zählers (16) ausgegeben wird, wobei das Ausgaberegister (17) bei Vorliegen des Rücksetzsignals des zweiten Schaltungsabschnitts (18-22) aktiviert wird.

2. Digitaler Phasenregelkreis nach Anspruch 1,
   **dadurch gekennzeichnet,**
   **daß** der Ausgabetakt (f) des digital gesteuerten Oszillators (3) der Phasendetektoreinrichtung (1) über mindestens einen Frequenzteiler (4, 5) zugeführt ist.

3. Digitaler Phasenregelkreis nach Anspruch 1 oder 2,
   **dadurch gekennzeichnet,**
   **daß** der Referenztakt ($f_{ref}$) der Phasendetektoreinrichtung (1) über mindestens einen Frequenzteiler (6) zugeführt ist.

4. Digitaler Phasenregelkreis nach einem der vorhergehenden Ansprüche,
   **dadurch gekennzeichnet,**
   **daß** der digital gesteuerte Oszillator (3) als Quarzoszillator ausgestaltet ist.

5. Digitaler Phasenregelkreis nach Anspruch 1,
   **dadurch gekennzeichnet,**
   **daß** die Quantisiereinrichtung (8) einen dritten Schaltungsabschnitt (23) aufweist, der derart ausgestaltet ist, daß er feststellt, wenn das von dem ersten Schaltungsabschnitt (12-14) erzeugte digitale Differenzwertsignal (Ud) keine Impulse aufweist und in diesem Fall den von dem Ausgaberegister (17) ausgegebenen letzten digitalen Wert durch den Wert Null ersetzt.

6. Digitaler Phasenregelkreis nach einem der vorhergehenden Ansprüche,
   **dadurch gekennzeichnet,**
   **daß** die Phasendetektoreinrichtung (1) eine Pulsdetektoreinrichtung (7) und eine Addiereinrichtung (9) umfaßt,
   wobei die Pulsdetektoreinrichtung (7) derart ausgestaltet ist, daß sie das Auftreten von Pulsen des ersten Impulssignals (AUF) und des zweiten Impulssignals (AB) überwacht und
   abhängig davon, ob ein Puls in dem ersten Impulssignal (AUF) oder dem zweiten Impulssignal (AB) auftritt, einen digitalen Korrekturwert erzeugt, und
   wobei der digitale Korrekturwert der Pulsdetektoreinrichtung (7) und der digitale Ausgabewert der Quantisiereinrichtung (8) der Addiereinrichtung (9) zur Addition zugeführt ist, so daß die Addiereinrichtung (9) den daraus resultierenden digitalen Summenwert als den digitalen Stellwert dem digitalen Schleifenfilter (2) zuführt.

7. Digitaler Phasenregelkreis nach Anspruch 6,
   **dadurch gekennzeichnet,**
   **daß** die Pulsdetektoreinrichtung (7) der Phasendetektoreinrichtung (1) derart ausgestaltet ist, daß sie den digitalen Korrekturwert in Form eines Impulssignals mit programmierbarer Pulslänge erzeugt.

## Claims

1. Digital phase-locked loop,
   having a digitally controlled oscillator (3) for generating a specific output clock (f),
   having a phase detector device (1) for detecting the analog phase difference between a clock which is dependent on the output clock (f) of the digitally controlled oscillator (3) and a reference clock ($f_{ref}$) and for converting the detected analog phase difference into a corresponding digital control value for the digitally controlled oscillator (3), and
   having a digital loop filter (2), via which the digital control value of the phase detector device (1) is fed to the digitally controlled oscillator (3) for the purpose of setting its output clock (f),
   the phase detector device (1) comprising a phase detector (24) and a quantizing device (8),
   the phase detector (24) generating a first pulse signal (UP) and a second phase signal (DOWN) in a manner dependent on the phase difference, a pulse of the first pulse signal (UP) being generated if the clock which is dependent on the output clock (f) of the digitally controlled oscillator (3) is less than the reference clock ($f_{ref}$), while a pulse of the second pulse signal (UP) is generated if the clock which is dependent on the output clock (f) of the digitally controlled oscillator (3) is greater than the reference clock ($f_{ref}$), and

the quantizing device (8) has a first circuit section (12-14) for sampling the first and second pulse signals (UP, DOWN) and for subtracting the thus obtained samples of the first and second pulse signals (UP, DOWN) in order thus to generate a corresponding digital difference value (Ud), and

the quantizing device (8) has a counter (16), whose counter reading is altered in a manner dependent on the respectively generated digital difference value (Ud) of the first circuit section (12-14), the counter reading of the counter (16) serving as a basis for the digital control value,

**characterized in that**

the quantizing device (8) has a second circuit section (18-22), which is configured in such a way that the digital difference value signal generated by the first circuit section (12-14) is monitored for the end of a pulse and, in this case, a reset signal is generated for the counter (16) for resetting the counter reading thereof, and

**in that** the quantizing device (8) has an output register (17), via which the instantaneous counter reading of the counter (16) is output, the output register (17) being activated when the reset signal of the second circuit section (18-22) is present.

2.  Digital phase-locked loop according to claim 1, **characterized in that**,
    the output clock (f) of the digitally controlled oscillator (3) is fed to the phase detector device (1) via at least one frequency divider (4, 5).

3.  Digital phase-locked loop according to claim 1 or 2, **characterized in that**,
    the reference clock ($f_{ref}$) is fed to the phase detector device (1) via at least one frequency divider (6).

4.  Digital phase-locked loop according to one of the preceding claims,
    **characterized in that**,
    the digitally controlled oscillator (3) is configured as a crystal oscillator.

5.  Digital phase-locked loop according to claim 1, **characterized in that**,
    the quantizing device (8) has a third circuit section (23), which is configured in such a way that it ascertains if the digital difference value signal (Ud) generated by the first circuit section (12-14) has no pulses and, in this case, replaces the last digital value output by the output register (17) by the value zero.

6.  Digital phase-locked loop according to one of the preceding claims,
    **characterized in that**,

the phase detector device (1) comprises a pulse detector device (7) and an addition device (9),

the pulse detector device (7) being configured in such a way that it monitors the occurrence of pulses of the first pulse signal (UP) and of the second pulse signal (DOWN) and generates a digital correction value depending on whether a pulse occurs in the first pulse signal (UP) or the second pulse signal (DOWN), and

the digital correction value of the pulse detector device (7) and the digital output value of the quantizing device (8) being fed to the addition device (9) for addition, so that the addition device (9) feeds the resultant digital summation value as the digital control value to the digital loop filter (2).

7.  Digital phase-locked loop according to claim 6, **characterized in that**,
    the pulse detector (7) of the phase detector device (1) is configured in such a way that it generates the digital correction value in the form of a pulse signal having a programmable pulse length.

**Revendications**

1.  Boucle à verrouillage de phase numérique,
    qui comporte
    un oscillateur à commande numérique (3) pour la production d'une certaine horloge de sortie (f),
    un dispositif détecteur de phase (1) pour la détection de la différence de phase analogique entre une horloge dépendante de l'horloge de sortie (f) de l'oscillateur à commande numérique (3) et une horloge de référence ($f_{ref}$) et pour la conversion de la différence de phase analogique détectée en une valeur réglante numérique correspondante pour l'oscillateur à commande numérique (3), et
    un filtre de boucle numérique (2) par l'intermédiaire duquel la valeur réglante numérique du dispositif détecteur de phase (1) est envoyée à l'oscillateur à commande numérique (3) pour le réglage de son horloge de sortie (f),
    et dans laquelle
    le dispositif détecteur de phase (1) comprend un détecteur de phase (24) et un dispositif de quantification (8),
    le détecteur de phase (24) produit en fonction de la différence de phase un premier signal à impulsions (AUF) et un deuxième signal à impulsions (AB), une impulsion du premier signal à impulsions (AUF) étant produite si l'horloge dépendante de l'horloge de sortie (f) de l'oscillateur à commande numérique (3) est inférieure à l'horloge de référence ($f_{ref}$) tandis qu'une impulsion du deuxième signal à impulsions (AB) est produite si l'horloge dépendante de l'horloge de sortie (f) de l'oscillateur à commande numérique (3) est supérieure à l'horloge de référence (f$_{ref}$), et

le dispositif de quantification (8) comporte un premier tronçon de circuit (12 à 14) pour l'échantillonnage du premier et du deuxième signal à impulsions (AUF, AB) et pour la soustraction des valeurs échantillonnées ainsi obtenues du premier et du deuxième signal à impulsions (AUF, AB) afin de produire ainsi une valeur de différence numérique (Ud) correspondante, et

le dispositif de quantification (8) comporte un compteur (16) dont l'état de compteur est modifié en fonction de la valeur de différence numérique (Ud) respectivement produite du premier tronçon de circuit (12 à 14), l'état du compteur (16) servant de base pour la valeur réglante numérique,

**caractérisée par le fait que**

le dispositif de quantification (8) comporte un deuxième tronçon de circuit (18 à 22) qui est conçu de telle sorte que le signal de valeur de différence numérique produit par le premier tronçon de circuit (12 à 14) est surveillé pour détecter la fin d'une impulsion et, dans ce cas, un signal de remise à zéro est produit pour le compteur (16) pour la remise à zéro de son état de compteur, et

le dispositif de quantification (8) comporte un registre de sortie (17) par l'intermédiaire duquel l'état momentané du compteur (16) est délivré, le registre de sortie (17) étant activé en présence du signal de remise à zéro du deuxième tronçon de circuit (18 à 22).

2. Boucle à verrouillage de phase numérique selon la revendication 1,

**caractérisée par le fait que** l'horloge de sortie (f) de l'oscillateur à commande numérique (3) est envoyée au dispositif détecteur de phase (1) par l'intermédiaire d'au moins un diviseur de fréquence (4, 5).

3. Boucle à verrouillage de phase numérique selon la revendication 1 ou 2,

**caractérisée par le fait que** l'horloge de référence (f$_{ref}$) est envoyée au dispositif détecteur de phase (1) par l'intermédiaire d'au moins un diviseur de fréquence (6).

4. Boucle à verrouillage de phase numérique selon l'une des revendications précédentes,

**caractérisée par le fait que** l'oscillateur à commande numérique (3) est conçu comme un oscillateur à quartz.

5. Boucle à verrouillage de phase numérique selon la revendication 1,

**caractérisée par le fait que** le dispositif de quantification (8) comporte un troisième tronçon de circuit (23) qui est conçu de telle sorte qu'il détermine si le signal de valeur de différence numérique (Ud) produit par le premier tronçon de circuit (12 à 14) ne comporte pas d'impulsions et, dans ce cas, remplace la dernière valeur numérique délivrée par le registre de sortie (17) par la valeur nulle.

6. Boucle à verrouillage de phase numérique selon l'une des revendications précédentes,

**caractérisée par le fait que**

le dispositif détecteur de phase (1) comprend un dispositif détecteur d'impulsion (7) et un dispositif additionneur (9),

le dispositif détecteur d'impulsion (7) étant conçu de telle sorte qu'il surveille l'apparition d'impulsions du premier signal à impulsions (AUF) et du deuxième signal à impulsions (AB) et qu'il produit une valeur correctrice numérique dépendante du fait qu'une impulsion apparaît dans le premier signal à impulsions (AUF) ou dans le deuxième signal à impulsions (AB), et

la valeur correctrice numérique du dispositif détecteur d'impulsion (7) et la valeur de sortie numérique du dispositif de quantification (8) étant envoyées au dispositif additionneur (9) en vue de leur addition de telle sorte que le dispositif additionneur (9) envoie la valeur cumulée numérique résultante comme valeur réglante numérique au filtre de boucle numérique (2).

7. Boucle à verrouillage de phase numérique selon la revendication 6,

**caractérisée par le fait que** le dispositif détecteur d'impulsion (7) du dispositif détecteur de phase (1) est conçu de telle sorte qu'il produit la valeur correctrice numérique sous la forme d'un signal à impulsions avec longueur d'impulsion programmable.

# FIG 1

# FIG 2

# FIG 3

Idealer
Phasendetektor

$\Delta\phi$  Ausgangssignal eines
idealen Phasendetektors

Ausgangssignal
des Quantisierers

Ausgangssignal des
Phasen/Frequenz-Detektors

Zeit

I1  $+$  $\Sigma$  $\Delta\phi$
$-$
I2

# FIG 4

$f_S$

7

10  $\{1, 0, -1\}$  11  $\{1, 0, -1\}$

AUF  Puls-  2  Programmierbare  2
AB  detektor  Pulsverlängerung

L

**FIG 5**

AUF → 12 $z^{-1}$ {1, 0}

AB → 13 $z^{-1}$ {1, 0}

14 Σ + / −

$U_d$ {1, 0, -1}

15 Entfernen des 1. Abtastwerts

$U_{d1}$

8

16 Aufwärts/ Abwärts-Zähler R

$n_{SA}$

17 $z^{-1}$ E

$n_{SA}$

18 ABS

19 NOT

20 $z^{-1}$

21 AND

22 OR

23 Überwachungs- schaltung R

EP 1 290 800 B1